Europäisches Patentamt

(19) European Patent Office

Office européen des brevets

(11) Publication number : **0 328 290 B1**

(12) **EUROPEAN PATENT SPECIFICATION**

(45) Date of publication of patent specification :
23.09.92 Bulletin 92/39

(51) Int. Cl.⁵ : **H01L 41/18**

(21) Application number : **89300937.3**

(22) Date of filing : **31.01.89**

(54) **Electrostriction element and ceramic material therefor.**

(30) Priority : **05.02.88 JP 23769/88**
**15.04.88 JP 91759/88**
**15.04.88 JP 91760/88**
**15.04.88 JP 91761/88**
**15.04.88 JP 91762/88**
**15.04.88 JP 91763/88**

(43) Date of publication of application :
**16.08.89 Bulletin 89/33**

(45) Publication of the grant of the patent :
**23.09.92 Bulletin 92/39**

(84) Designated Contracting States :
**DE FR GB IT NL**

(56) References cited :
**DE-B- 1 696 424**
**US-A- 3 144 411**

(56) References cited :
**FERROELECTRICS, vol. 27, 1980, pages 41-43, Gordon and Bresch, Science Publishers, Inc., US; K.M. LEUNG et al.: "Largeelectrostrictive effect in Ba:PZT and its application" JOURNAL OF APPLIED PHYSICS, vol. 49, no. 7, July 1978, pages 4296-4297, American Institute of Physics, New York, US; P.C.LYSNE: "Electrical response of a slim-loop-ferroelectric ceramic compressed by shock waves"**

(73) Proprietor : **MITSUI TOATSU CHEMICALS, Inc.**
**2-5 Kasumigaseki 3-chome**
**Chiyoda-Ku Tokyo 100 (JP)**

(72) Inventor : **Hagimura, Atsushi**
**1-4-21-204 Kobukurodani**
**Kamakura-shi, Kanagawa-ken (JP)**
Inventor : **Uchino, Kenji, Towa Totsuka Corp.**
**No. 103, 42002-2, Totsuka-cho, Totsuka-ku**
**Yokohama-shi, Kanagawa-ken (JP)**

(74) Representative : **Hayward, Denis Edward Peter et al**
**Lloyd Wise, Tregear & Co. Norman House**
**105-109 Strand**
**London WC2R 0AE (GB)**

Jouve, 18, rue Saint-Denis, 75001 PARIS

## Description

The present invention relates to an electrostriction transducer, and more particularly to an electrostriction transducer which is suitable for fine position-controlling of various mechanical elements and to a ceramic material which is suitable for manufacturing the transducer.

Recently, in order to manufacture at a high production rate VLSI (Very Large Scale Integration) means to a larger scale and of higher reliability, a technique for measuring and controlling the positions of various elements in the manufacturing apparatus and of increments to a sub-micron order is required.

Further, in other technical fields, for example precision machine working, optical instruments, or astronomy, an actuator has been required which is able to regulate at a sub-micron order a position or displacement of various machine elements or an optical path length.

A piezoelectric element or an electrostriction transducer is an extremely important machine element as a sensor for position-detecting or an actuator for position-controlling.

Heretofore, as such kind of actuators, an electric motor provided with gearing for converting rotational motion to translation movement is used, or an electric current/displacement convertor is used, in which an electromagnetic coil, a permanent magnet, and a spring are combined.

Although these actuators are widely used, they are complex in construction and the controlling device therefor is also complex, the force generated or produced by such actuators is small, and the response of such actuators is insufficient. Therefore, a transducer of higher performance has been desired in the fields of optics and precise machines.

In various machine tools such as optical or electronic cameras, measuring apparatus utilizing a laser, and in the positioning of the work in a manufacturing apparatus for large scale integrated circuits, the required precision has already reached an order of 0.1 micron, and this requirement for precision will become increasingly severe.

Under such circumstances, recently, an electrostriction actuator as a new actuator has suddenly been spotlighted, and its development in the future is also expected as a new commodity in the electronic ceramics market.

Generally, as manipulated variables for controlling solid state conversion elements, temperature, magnetic field, and electric field are considered. Among these, an element utilizing temperature change has the disadvantages that it is slow in response, deficient in steadiness, and requires a large energy for the drive. An element utilizing a magnetic field has the disadvantages that it has a small strain factor, requires a driving coil, and thus the apparatus will become larger in size.

In an electric field/strain transducer, there are the choices of a piezoelectric element and an electrostriction element. An electrostriction material has generally the advantages over a piezoelectric material that it is small in its hysteresis error, does not require any polarization process, and is able to withstand severe conditions of use.

However, any such element has the problem that it is small in its strain factor. Although this problem is being overcome step by step owing to the outcome from recent studies, the strain factor has not reached a sufficient level yet.

The former, i.e. piezoelectric element, is exemplified by PZT (Lead-Zirconare-Titanate).

Although this ceramic presents an elongation of 0.06% within an electric field of 10 kV/cm, the hysteresis error amounts to 15 to 30%. Therefore, in order to accurately control the strain, a complicated program is required.

The latter, i.e. the electrostriction element, is exemplified by PMN $(Pb(Mg\ Nb)0_3]$. This has a hysteresis error as small as 5 to 10% and an elongation of 0.06% within an electric field of 10 kV/cm. However, this material has a problem that it has a large dielectric constant and thus requires a large electric power for the drive, and therefore the self-heat value becomes relatively large.

As an electrostriction material other than PMN, ceramics represented by [Pb, Ba] [Zr, Ti] $0_3$ (hereinafter referred to as PBZT) are known.

The ceramics of this series were already reported by K.M. Leung et al of HANEY WELL CO. (See Ferroelectrics, 1980, vol. 27, pp. 41 to 43).

They reported, in the above, ceramics having a composition of $Pb_{0.73}\ Ba_{0.27}\ Bi_{0.02}\ Zr_{0.70}\ Ti_{0.30}\ 0_3$. According to the report, elongation in the maximum electric field of 10 kV/cm is 0.06%.

Further, ceramics having a composition of $(Pb_{0.715}\ Ba_{0.285})_{0.991}\ (Zr_{0.707}\ Ti_{0.293})_{0.981}\ Bi_{0.019}\ 0_3$ have been reported by P.C. Lysne in J. Appl. Phys. 49(7), July 1978, pp. 4296-4297.

Japanese Patent Laid-Open Publication Sho JP-A-60-144984 discloses ceramics consisting of PBZT with Bi or W being added thereto. The ceramics based on the invention of this publication have the composition represented by the following formula:

$$[Pb_x\, Ba_{1-x}]\, [Zr_y\, Ti_{1-y}]\, O_3$$

where

$$0.75 \leq x \leq 0.83$$
$$0.53 \leq y \leq 0.55$$

Although the hysteresis error of these ceramics is not disclosed in the above papers, it is assumed to be very large.

Further, although many techniques are disclosed for substituting a part of the Pb in PZT with alkali metal or alkaline earth metal, the amount of Pb substituted by these prior art proposals is not more than 30%.

Therefore, the ceramics actuator of the present invention should have the following requirements:

(1) a large strain factor (strain in the maximum electric field);
(2) a small hysteresis error;
(3) a superior response;
(4) a superior repeatability;
(5) slight influence by temperature variations;
(6) drivability by means of a small amount of energy;
(7) a large generated stress;
(8) a small size and weight;
(9) a slight secular change and a long effective life; and
(10) a homogeneous product mass-produced at a low cost.

Such a ceramic material that fulfils all the above requirements is not hitherto known.

The present invention provides a ceramic material represented by the composition formula,

$$[Pb_x\, Ba_{1-x}]_m\, [Zr_y\, Ti_{1-y}]_n\, [M]_\ell\, O_3\ ;$$

where

$$0.55 \leq x \leq 0.70$$
$$0.45 \leq y \leq 0.80$$
$$0.85 \leq m \leq 1.15$$
$$0.85 \leq n \leq 1.15$$
$$0.001 \leq \ell \leq 0.1$$

M is a metal selected from a group consisting of:

divalent Cu, Mg, Ni, Zn;

trivalent Bi, Nd, Y;

tetravalent Ce, Ge, Hf, Mn, Sn, Te, Th;

pentavalent Cr, Mn, Nb, Sb, Ta; and

sexivalent Cr, Mn, Mo, W.

By the present invention, a ceramic material which has a significantly large strain factor and a very small hysteresis error, in comparison with the prior-published materials in the prior art, can be provided for an electrostriction transducer.

In the present specification, the strain factor refers to elongation percentage per unit electric field, that is, the value determined by the following formula:

$$\frac{\Delta L}{L\, E} \times 100\ (\%)$$

where L = length of the transducer measured in the direction of the electric field,

$\Delta L$ = elongation in an electric field of E kV/cm.

The maximum strain factor refers to the strain factor within an electric field of 10 kV/cm. The hysteresis error refers to the value represented by the following formula:

$$\frac{\Delta L^- - \Delta L^+}{L_{max}} \times 100\ (\%)$$

where

$\Delta L^-$ = elongation of the transducer when the strength of the electric field is lowered from 10 kV/cm to 5 kV/cm,

$\Delta L^+$ = elongation of the transducer when the strength of the electric field is raised from 0 kV/cm to 5 kV/cm.

$L_{max}$ = maximum elongation in an electric field of 10 kV/cm.

In the ceramics according to the present invention, the maximum strain factor is about 1.5 to 2 times (i.e. 0.12%) that of the prior art material and the hysteresis error is lower than half (i.e. 2 to 15%) that of the prior art.

Electrostriction transducers of such material having a large strain factor and a small hysteresis error can be widely utilized in various technical fields, for example, various machine tools, ink-dot-printers and the focusing of a microscope.

In the present invention, when x becomes less than 0.55 the strain factor is lowered; when x exceeds 0.70, the hysteresis error becomes larger; when y becomes less than 0.50, the hysteresis error becomes larger; and when y exceeds 0.80, the strain factor decreases.

Therefore, it is desirable that x is not smaller than 0.55 and is not larger than 0.70, and y is not smaller than 0.50 and is not larger than 0.80.

Further, it is required that each of m and n is not smaller than 0.85 and is not larger than 1.15 in order to maintain electrical neutrality.

When $\ell$ is less than 0.001, the effect of added M does not appear, and when $\ell$ exceeds 0.1, the strain factor decreases.

Now, a method for manufacturing the ceramic material according to the present invention will be described hereunder.

First, the raw materials will be described. As to lead, for a raw material lead oxide is most suitable, but it may be lead carbonate, lead oxalate, or lead hydroxide, etc.

Regarding barium, barium carbonate is recommended, but it may be barium oxide, or barium oxalate, etc.

Relating to zirconium, zirconium oxide is desirable, but it may be zirconium carbonate, zirconium oxalate, or zirconium hydroxide.

With respect to titanium, titanium oxide is recommended, but it may be titanium carbonate, titanium oxalate, or titanium hydroxide.

Metal M is added in the form of its oxide, nitride, or fluoride.

These raw materials are measured or weighed and then are mixed at a pre-determined ratio.

As the mixing apparatus, a ball mill is desirable, but it may be any other apparatus which is commonly used to mix powders, for example a homogeniser, an attrition mill, or a vibrating mixer. The time period necessary for mixing the raw materials depends on the mixing apparatus and the properties of the raw materials, but it is generally within the range of 2 to 20 hours. This time period is, of course, not limited to said particular range.

Next, the powders of these raw materials thus obtained are calcined. The calcination temperature is within the range of 600 to 1000°C, preferably 800 to 900°C. The calcination is preferably carried out in air for 1 to 10 hours. The desired strain factor cannot be obtained when the calcination temperature is under 600°C. On the other hand, if the calcination temperature is not lower than 1000°C, the grains become too large. Further, even if the time of calcination is extended beyond 10 hours, there is no further effect noted and thus calcination over 10 hours is not desirable from the economic view point. The calcination can be performed in nitrogen gas, oxygen gas, or argon gas as well as in air.

The calcined powders are fine-ground in the next process. As the fine-grinding apparatus, for example a ball mill, a vibrating mill or an attrition mill can be used, whereby the raw materials are fine-ground to an order of 80 mesh or so. The purpose of such fine-grinding is to eliminate any undesirable grain growth caused by the calcination process.

Next, the fine powders are compressed at high pressure thereby to be formed into a desired configuration, for example a disk, a column, or a square pillar. A forming pressure of 9.81 MPa to 294.3 Mpa (100 to 3000 kP/cm²) is generally sufficient.

Next, this formed material is sintered at a temperature within the range of 1100 to 1400°C. If the sintering temperature is not higher than 1100°C, a dense sintered body having the desired high density cannot be obtained. On the other hand, if the sintering temperature exceeds 1400°C, a part of the material may possibly be melted. The most desirable sintering temperature is 1200 to 1350°C.

As to the atmosphere in which the sintering is performed, air is most desirable but it may be nitrogen gas, oxygen gas, or argon gas, etc.

Next, the body thus sintered is cut into slices having a pre-determined thickness, an electrode material including platinum or silver is applied to both sides of each slice and the electrode material is baked on to obtain electrostriction elements.

Since a single such plate element exhibits only a small strain, 50 to 100 pieces are laminated as required for use. Examples

PbO, BaCO₃, ZrO₂, TiO₂, and an oxide of metal M were weighed, and mixed by means of a ball mill for 10 hours. The mixture thus obtained was calcined at a temperature within the range of 800 to 900°C for two hours, and then was fine-ground again by the ball mill. After this mixture was dried, it was press-formed into a cylinder with a pressure of 147.15 MPa (1500 kp/cm²) It was sintered at a temperature within the range of 1200 to 1350°C for three hours, and the cylinder body thus obtained was cut into slices having a thickness of 0.80mm. A platinum electrode material was applied on to both sides of a slice and baked to thereby obtain a single electrostriction transducer. The electrodes were connected to a DC power source of 800V, and the elongation and hysteresis were measured. The strength of the electric field was 10 kV/cm.

4

The measured results are shown in Tables 1 to 5. Table 1A shows data about ceramic mixtures according to the invention, employing Bi as the metal M. Table 1B shows comparative examples of ceramics outside the scope of the invention, again including Bi as the metal M.

Similarly, Tables 2A, 3A, 4A and 5A show, respectively, the data about ceramics according to the invention employing Nb, W, Th and Ta as the metal M. Tables 2B, 3B, 4B and 5B show comparative examples of mixtures outside the scope of the invention, using the same metal M as in the corresponding one of the Tables 2A, 3A, 4A and 5A.

As noted from Tables 1A to 5A, for instance, in the ceramics according to the present invention, the hysteresis error is as small as 2 to 5% and the maximum strain factor is as large as 0.06 to 0.09%.

In the comparative examples of Tables 1B to 5B, the ceramics having the same hysteresis error as the ceramics of the present invention show a maximum strain factor of 0.02 to 0.03%, and conversely, the ceramics having the same maximum strain factor as that of the ceramics of the present invention show a hysteresis error of 15 to 35%.

Until now, it was considered that, within the range of composition of the ceramics according to the present invention, only a very small strain factor could be obtained.

### T A B L E   1 A

| No. | x | y | m | n | Bi | $S_{max}$ | H.E. |
|---|---|---|---|---|---|---|---|
| 1 | 0.60 | 0.55 | 0.97 | 1.00 | 2 | 0.075% | 5% |
| 2 | 0.60 | 0.70 | 0.97 | 1.00 | 2 | 0.061 | 2 |
| 3 | 0.65 | 0.70 | 0.97 | 1.00 | 2 | 0.071 | 3 |
| 4 | 0.67 | 0.55 | 0.97 | 1.00 | 2 | 0.068 | 4 |
| 5 | 0.69 | 0.70 | 0.97 | 1.00 | 2 | 0.080 | 4 |
| 6 | 0.69 | 0.70 | 0.97 | 1.00 | 4 | 0.091 | 5 |

T A B L E   1 B

| No. | x | y | m | n | Bi | S max | H.E. |
|---|---|---|---|---|---|---|---|
| 7 | 0.73 | 0.70 | 0.97 | 1.00 | 2 | 0.090% | 16% |
| 8 | 0.73 | 0.55 | 0.97 | 1.00 | 2 | 0.130 | 23 |
| 9 | 0.65 | 0.40 | 0.97 | 1.00 | 2 | 0.130 | 35 |
| 10 | 0.69 | 0.70 | 0.97 | 1.00 | 0 | 0.050 | 35 |
| 11 | 0.50 | 0.70 | 0.97 | 1.00 | 2 | 0.038 | 4 |
| 12 | 0.50 | 0.55 | 0.97 | 1.00 | 2 | 0.021 | 5 |
| 13 | 0.65 | 0.85 | 0.97 | 1.00 | 2 | 0.031 | 4 |
| 14 | 0.69 | 0.70 | 0.97 | 1.00 | 12 | 0.017 | 2 |
| 15 | 0.69 | 0.70 | 0.80 | 1.00 | 2 | 0.025 | 2 |
| 16 | 0.69 | 0.70 | 1.20 | 1.00 | 2 | 0.018 | 5 |
| 17 | 0.69 | 0.70 | 0.97 | 0.80 | 2 | 0.025 | 5 |
| 18 | 0.69 | 0.70 | 0.97 | 1.20 | 2 | 0.030 | 3 |

T A B L E   2 A

| No. | x | y | m | n | Nb | S max | H.E. |
|---|---|---|---|---|---|---|---|
| 1 | 0.60 | 0.55 | 1.00 | 0.975 | 2 | 0.085% | 5% |
| 2 | 0.60 | 0.70 | 1.00 | 0.975 | 2 | 0.060 | 4 |
| 3 | 0.65 | 0.70 | 1.00 | 0.975 | 2 | 0.072 | 4 |
| 4 | 0.67 | 0.55 | 1.00 | 0.975 | 2 | 0.068 | 5 |
| 5 | 0.69 | 0.70 | 1.00 | 0.975 | 2 | 0.085 | 5 |
| 6 | 0.69 | 0.70 | 1.00 | 0.975 | 4 | 0.088 | 3 |

6

T A B L E E   2 B

| No. | x | y | m | n | Nb | $S_{max}$ | II.E. |
|---|---|---|---|---|---|---|---|
| 7 | 0.73 | 0.70 | 1.00 | 0.975 | 2 | 0.098% | 16% |
| 8 | 0.73 | 0.55 | 1.00 | 0.975 | 2 | 0.130 | 25 |
| 9 | 0.65 | 0.40 | 1.00 | 0.975 | 2 | 0.140 | 35 |
| 10 | 0.69 | 0.70 | 1.00 | 0.975 | 0 | 0.050 | 35 |
| 11 | 0.50 | 0.70 | 1.00 | 0.975 | 2 | 0.028 | 4 |
| 12 | 0.50 | 0.55 | 1.00 | 0.975 | 2 | 0.022 | 5 |
| 13 | 0.65 | 0.85 | 1.00 | 0.975 | 2 | 0.032 | 4 |
| 14 | 0.69 | 0.70 | 1.00 | 0.975 | 12 | 0.017 | 2 |
| 15 | 0.69 | 0.70 | 0.80 | 0.975 | 2 | 0.020 | 2 |
| 16 | 0.69 | 0.70 | 1.20 | 0.975 | 2 | 0.018 | 5 |
| 17 | 0.69 | 0.70 | 1.00 | 0.80 | 2 | 0.025 | 4 |
| 18 | 0.69 | 0.70 | 1.00 | 1.20 | 2 | 0.020 | 2 |

T A B L E   3 A

| No. | x | y | m | n | W | $S_{max}$ | II.E. |
|---|---|---|---|---|---|---|---|
| 1 | 0.60 | 0.55 | 1.00 | 0.97 | 2 | 0.068% | 5% |
| 2 | 0.60 | 0.70 | 1.00 | 0.97 | 2 | 0.060 | 4 |
| 3 | 0.65 | 0.70 | 1.00 | 0.97 | 2 | 0.072 | 4 |
| 4 | 0.67 | 0.55 | 1.00 | 0.97 | 2 | 0.079 | 5 |
| 5 | 0.69 | 0.70 | 1.00 | 0.97 | 2 | 0.080 | 5 |
| 6 | 0.69 | 0.70 | 1.00 | 0.97 | 4 | 0.088 | 3 |

T A B L E    3 B

| No. | x | y | m | n | W | $S_{max}$ | H.E. |
|---|---|---|---|---|---|---|---|
| 7 | 0.73 | 0.70 | 1.00 | 0.97 | 2 | 0.120% | 40% |
| 8 | 0.73 | 0.55 | 1.00 | 0.97 | 2 | 0.100 | 25 |
| 9 | 0.65 | 0.40 | 1.00 | 0.97 | 2 | 0.120 | 35 |
| 10 | 0.69 | 0.70 | 1.00 | 0.97 | 0 | 0.050 | 35 |
| 11 | 0.50 | 0.70 | 1.00 | 0.97 | 2 | 0.024 | 4 |
| 12 | 0.50 | 0.55 | 1.00 | 0.97 | 2 | 0.022 | 5 |
| 13 | 0.65 | 0.85 | 1.00 | 0.97 | 2 | 0.022 | 4 |
| 14 | 0.69 | 0.70 | 1.00 | 0.97 | 12 | 0.017 | 2 |
| 15 | 0.69 | 0.70 | 0.80 | 0.97 | 2 | 0.020 | 2 |
| 16 | 0.69 | 0.70 | 1.20 | 0.97 | 2 | 0.025 | 3 |
| 17 | 0.69 | 0.70 | 1.00 | 0.80 | 2 | 0.023 | 5 |
| 18 | 0.69 | 0.70 | 1.00 | 1.20 | 2 | 0.018 | 4 |

T A B L E    4 A

| No. | x | y | m | n | Th | $S_{max}$ | H.E. |
|---|---|---|---|---|---|---|---|
| 1 | 0.60 | 0.55 | 0.96 | 1.00 | 2 | 0.090% | 5% |
| 2 | 0.60 | 0.70 | 0.96 | 1.00 | 2 | 0.060 | 4 |
| 3 | 0.65 | 0.70 | 0.96 | 1.00 | 2 | 0.066 | 4 |
| 4 | 0.67 | 0.55 | 0.96 | 1.00 | 2 | 0.062 | 5 |
| 5 | 0.69 | 0.70 | 0.96 | 1.00 | 2 | 0.076 | 5 |
| 6 | 0.69 | 0.70 | 0.96 | 1.00 | 4 | 0.088 | 3 |

TABLE 4 B

| No. | x | y | m | n | Th | S max | I.E. |
|---|---|---|---|---|---|---|---|
| 7 | 0.73 | 0.70 | 0.96 | 1.00 | 2 | 0.100% | 20% |
| 8 | 0.73 | 0.55 | 0.96 | 1.00 | 2 | 0.150 | 25 |
| 9 | 0.65 | 0.40 | 0.96 | 1.00 | 2 | 0.155 | 40 |
| 10 | 0.69 | 0.70 | 0.96 | 1.00 | 0 | 0.050 | 35 |
| 11 | 0.50 | 0.70 | 0.96 | 1.00 | 2 | 0.028 | 3 |
| 12 | 0.50 | 0.55 | 0.96 | 1.00 | 2 | 0.032 | 5 |
| 13 | 0.65 | 0.85 | 0.96 | 1.00 | 2 | 0.022 | 4 |
| 14 | 0.69 | 0.70 | 0.96 | 1.00 | 12 | 0.017 | 2 |
| 15 | 0.69 | 0.70 | 0.80 | 1.00 | 2 | 0.020 | 2 |
| 16 | 0.69 | 0.70 | 1.20 | 1.00 | 2 | 0.018 | 5 |
| 17 | 0.69 | 0.70 | 0.96 | 0.80 | 2 | 0.025 | 4 |
| 18 | 0.69 | 0.70 | 0.96 | 1.20 | 2 | 0.020 | 2 |

TABLE 5 A

| No. | x | y | m | n | Ta | S max | I.E. |
|---|---|---|---|---|---|---|---|
| 1 | 0.60 | 0.55 | 1.00 | 0.975 | 2 | 0.090% | 5% |
| 2 | 0.60 | 0.70 | 1.00 | 0.975 | 2 | 0.060 | 4 |
| 3 | 0.65 | 0.70 | 1.00 | 0.975 | 2 | 0.070 | 4 |
| 4 | 0.67 | 0.55 | 1.00 | 0.975 | 2 | 0.062 | 5 |
| 5 | 0.69 | 0.70 | 1.00 | 0.975 | 2 | 0.076 | 5 |
| 6 | 0.69 | 0.70 | 1.00 | 0.975 | 4 | 0.082 | 5 |

T A B L E 5 B

| No. | x | y | m | n | Ta | S max | H.E. |
|-----|------|------|------|-------|----|---------|------|
| 7 | 0.73 | 0.70 | 1.00 | 0.975 | 2 | 0.120% | 30% |
| 8 | 0.73 | 0.55 | 1.00 | 0.975 | 2 | 0.160 | 25 |
| 9 | 0.65 | 0.40 | 1.00 | 0.975 | 2 | 0.175 | 30 |
| 10 | 0.69 | 0.70 | 1.00 | 0.975 | 0 | 0.050 | 35 |
| 11 | 0.50 | 0.70 | 1.00 | 0.975 | 2 | 0.035 | 3 |
| 12 | 0.50 | 0.55 | 1.00 | 0.975 | 2 | 0.032 | 3 |
| 13 | 0.65 | 0.85 | 1.00 | 0.975 | 2 | 0.040 | 4 |
| 14 | 0.69 | 0.70 | 1.00 | 0.975 | 12 | 0.020 | 2 |
| 15 | 0.69 | 0.70 | 0.80 | 0.975 | 2 | 0.020 | 3 |
| 16 | 0.69 | 0.70 | 1.20 | 0.975 | 2 | 0.025 | 4 |
| 17 | 0.69 | 0.70 | 1.00 | 0.80 | 2 | 0.018 | 2 |
| 18 | 0.69 | 0.70 | 1.00 | 1.20 | 2 | 0.028 | 3 |

In order to increase the strain factor of ceramics having the above-described composition, the present inventors added various metallic compounds to these ceramics, resulting in a new composition which has a strain factor of about 1.5 to 2 times that of the starting material and a hysteresis error of only half that of the starting material.

The feature of the ceramics according to the present invention is that they have a larger strain factor combined with a smaller hysteresis error than the known piezoelectric elements or electrostriction transducers used in the prior art.

The known piezoelectric elements have a hysteresis error of about 20 to 25%, whereas the hysteresis error of elements according to the present invention is a maximum of 15% and normally 2 to 5%. At the same time, the elements according to the present invention can achieve 1.5 to 2 times as large a strain factor as the elements of the prior art. This is an unexpected result.

The elements according to the present invention can be widely utilized as actuators for fine-regulating the position of a body and as sensors for detecting force, pressure or displacement.

**Claims**

1. A ceramic material represented by the following composition formula:
$$[Pb_x Ba_{1-x}]_m [Zr_y Ti_{1-y}]_n [M]_\ell O_3$$
where,
$$0.55 \leq x \leq 0.70$$
$$0.45 \leq y \leq 0.80$$
$$0.85 \leq m \leq 1.15$$
$$0.85 \leq n \leq 1.15$$

$$0.001 \leq \ell \leq 0.1$$

M is a metal selected from a group consisting of:

divalent Cu, Mg, Ni, Zn,

trivalent Bi, Nd, Y,

tetravalent Ce, Ge, Hf, Mn, Sn, Te, Th,

pentavalent Cr, Mn, Nb, Sb, Ta, and

sexivalent Cr, Mn, Mo, W.

2. A ceramic material according to claim 1, wherein said metal M is a metal selected from a group consisting of Bi, Nd, Y, Ce, Sn, Th, Nb, Ta, Mo, and W.

3. An electrostriction transducer comprising a slice made from the ceramic material according to claim 1 or claim 2 with each of both side faces of said slice being provided with an electrode.

4. An actuator comprising a slice made from the ceramic material according to claim 1 or claim 2 with each of both side faces of said slice being provided with an electrode.

**Patentansprüche**

I. Keramisches Material,

**gekennzeichnet** durch die Folgende Zusammensetzungsformel:

$$[Pb_x\ Ba_{l-x}]\ _m\ [Zr_y\ Ti_{l-y}]_n\ [M\ ]_l\ O_3$$

wobei bedeuten:

$$0,55 \leq x \leq 0,70$$

$$0,45 \leq y \leq 0,80$$

$$0,85 \leq m \leq 1,15$$

$$0,85 \leq n \leq 1,15$$

$$0,001 \leq l \leq 0,l$$

M ist ein Metall, ausgewählt aus einer Gruppe bestehend aus

divalent          Cu, Mg, Ni, Zn

trivalent          Bi, Nd, Y

tetravalent          Ce, Ge, HF, Mn, Sn, Te, Th

pentavalent          Cr, Mn, Nb, Sb, Ta und

sexivalent          Cr, Mn, Mo, W.

2. Keramisches Material gemäß Anspruch I, wobei das Metall M ein Metall ist, das aus einer Gruppe ausgewählt ist, welches besteht aus Bi, Nd, Y, Ce, Sn, Th, Nb, Ta, Mo und W.

3. Elektrostriktiver Wandler, bei dem die Scheibe aus dem keramischen Material gemäß Anspruch I oder Anspruch 2 hergestellt ist, wobei auf beiden Seitenflächen der Scheibe jeweils eine Elektrode angebracht ist.

4. Betätigungselement, bei dem die Scheibe aus dem keramischen Material gemäß Anspruch I oder Anspruch 2 hergestellt ist, wobei auf beiden Seitenflächen der Scheibe jeweils eine Elektrode angebracht ist.

**Revendications**

1. - Matériau céramique représenté par la formule de composition suivante:

$$[Pb_x\ Ba_{1-x}]_m\ [Zr_y\ Ti_{1-y}]_n\ [M]_\ell\ O_3$$

dans laquelle:

$$0,55 < x < 0,70$$

$$0,45 < y < 0,80$$

$$0,85 < m < 1;15$$

$$0,85 < n < 1,15$$

$$0,001 < \ell < 0,1$$

M est un métal choisi dans un groupe formé par les métaux:

divalents Cu, Mg, Ni, Zn,

trivalents Bi, Nd, Y,

tétravalents Ce, Ge, Hf, Mn, Sn, Te, Th,

pentavalents Cr, Mn, Sb, Ta, et

hexavalents Cr, Mn, Mo, W.

2. - Matériau céramique selon la revendication 1, dans lequel le métal M est un métal choisi dans un groupe formé par Bi, Nd, Y, Ce, Sn, Th, Nb, Ta, Mo et W.

3. - Transducteur à électrostriction comprenant une lame faite du matériau céramique selon la revendication 1 ou 2, chacune des deux faces de la lame étant munie d'une électrode.

4. - Actionneur comprenant une lame constituée du matériau céramique selon la revendication 1 ou la revendication 2, chacune des deux faces de la lame étant munie d'une électrode.